Europäisches Patentamt

European Patent Office

Office européen des brevets

(19)

(11) Publication number: 0 288 153
A2

# (12) EUROPEAN PATENT APPLICATION

(21) Application number: 88302526.4

(22) Date of filing: 23.03.88

(51) Int. Cl.⁴: **G03F 7/12 , G03F 7/06 , G03F 7/08**

(30) Priority: 26.03.87 GB 8707272

(43) Date of publication of application:
26.10.88 Bulletin 88/43

(84) Designated Contracting States:
AT BE CH DE ES FR GB IT LI NL SE

(71) Applicant: **Sericol Group Limited**
**24 Parsons Green Lane**
**London SW6 4HT(GB)**

(72) Inventor: **Day, Peter Michael**
**73 Gladstone Road**
**Broadstairs Kent(GB)**
Inventor: **Dickinson, Peter**
**11 Knights Avenue**
**Broadstairs Kent(GB)**

(74) Representative: **Claisse, John Anthony, Dr.**
**97 Portway**
**Wells Somerset BA5 2BR(GB)**

(54) Screen Compositions.

(57) Compositions for producing screen printing stencils by the direct emulsion method which include an aqueous, partially-saponified polyvinyl acetate solution in which is dissolved a photosensitive material capable of insolubilising the saponified polyvinyl acetate on exposure to light, certain acrylated prepolymers, and a suitable photoinitiator, the acrylated prepolymers being immiscible with water and being a non-solvent for the poylvinyl acetate.

Good exposure latitude can be achieved with easy stencil removal whilst providing tough resists with good definition.

EP 0 288 153 A2

This invention concerns compositions for producing screen printing stencils.

Screenprinting consists of the imagewise application of an ink on to a substrate by use of a stencil mounted on a screen. The method of application of the stencil to the screen is used to subdivide stencil types.

In one method a photosensitive emulsion is created directly on the screen using a trough or similar implement. This is know as the "direct emulsion" technique. The emulsion when dry is subjected to imagewise exposure by actinic light through a photographic positive, or other imaging technique, prior to developing with water to remove the unexposed coating. Alkali or solvents are sometimes used for the developing step.

Another technique utilises a photosensitive layer precoated onto a temporary support, usually a clear polyester film. The coating is exposed to actinic light through the clear support, and it is developed on the support prior to being transferred to the screen whilst still in a wet condition. This method is termed the "indirect film" technique.

More recently a "direct film" or capillary film method has been proposed in which the film, carried by a support which is usually a clear polyester film but is sometimes paper, is transferred to the screen with water, dried and exposed to actinic light. The image is then developed on the screen as in the "direct emulsion" technique.

A further technique known as the "direct-indirect" method utilises a film and an emulsion. Either or both is then made sensitive to actinic radiation using a sensitiser so that migration of the sensitiser occurs from one to the other. The screen in this case is placed on the film, coated side up, and a layer of the emulsion is drawn across the mesh of the screen so as to pass through the mesh and into contact with the coating on the film. The laminate formed is then dried, the support peeled away, and exposure and development is carried out as with the "direct film" method.

The use of films is generally considerably more expensive than the use of direct emulsions, and they currently give much improved print quality, for less effort. Films are recognised within the industry as giving excellent replication of the original image due to the ability of the stencil to lie flat upon the woven mesh of the screen, thus ensuring good overall contact with the substrate to be printed. This property of a screen is known as definition". Direct emulsions on the other hand generally give poor definition due to the combined effect of the "sag" within the emulsion and shrinkage due to evaporation on drying, and they more closely follow the undulations of the mesh of the screen. The result is poor contact with the substrate and consequently the printed image generally spreads under the stencil to give a poor replication of the image. This is an effect commonly called a "sawtooth" pattern. To make a stencil with current direct emulsions that will give good print definition requires a complex coating technique on the mesh, usually with intermediate drying stages between coats so as gradually to level out the mesh effects. Frequently the thickness or "build" of the stencil above the mesh, necessary to attain good definition is excessive, requiring greater ink usage. This is expensive, and often leads to other problems such as slow ink drying and colour match difficulties.

Direct emulsions are usually blends of aqueous solutions of partially saponified polyvinyl acetate, also referred to as polyvinyl alcohol, and also containing inert fillers, for example starch or aqueous polymer dispersions. These polymers; are usually polyvinyl acetate, or co-or ter-polymers of vinyl acetate. In order to render the coating insoluble on drying and exposure to actinic light, photosensitive materials are added, for example a dichromate salt or a diazo resin, the latter being prepared for example by the condensation of a diazo diphenylamine salt with a condensing agent such as formaldehyde.

Improvements in the build and definition of direct emulsions have, in the past, been achieved using emulsions with high solids contents, for example up to 46% by weight. These emulsions do provide a thicker coating on the screen, but on drying they still replicate the undulations of the woven mesh of the screen, due to sag and evaporation effects, resulting in poor print definition. Often increased solids contents have also produced emulsions of high viscosity, making coating of the stencils difficult, and in consequence build and definition tend to deteriorate.

Emulsions having high levels of inorganic or organic filler also tend to suffer from severe light scattering during exposure. This results in poor "exposure latitude" which is seen as under-exposed areas which readily fall away from the screen and over-exposed areas which tend to enlarge after developing.

Direct emulsions have been proposed where the polyvinyl alcohol has been insolubilised by an acrylic monomer in which is dissolved a sensitiser system. A bridging solvent, in which both polyvinyl alcohol and the acrylic monomer are partly or totally soluble, is used to bring the two phases into close proximity (see U.S. Patent Specification 4,118,272). British Patent Specification 2,109,392 also describes a system where acrylates and acrylated prepolymers can be used to render water soluble polyvinyl alcohol insoluble. The prepolymers concerned are low to medium molecular weight multifunctional unsaturated materials capable of interacting to form polymers.

Removal of the exposed stencil from the screen mesh after printing is difficult with these systems, the mesh generally being re-used several times for further stencils. It is necessary to degrade the poylmerised acrylic material, and this involves: procedures such as prolonged soaking in highly caustic liquids which frequently degrades the polyester or nylon of the mesh prior to removing the stencil.

Bridging solvents can also evaporate if the screen is left unexposed before exposure and this can result in stencils of poor quality.

The systems which render these emulsions insoluble are very fast acting and they result in stencils which show poor exposure latitude and are easily under-exposed and damaged or they are over-exposed to give an image which does not wash out completely when developed. These emulsions do have the advantage of great toughness and also high solids contents can easily be achieved to give good build and definition in the finished stencils.

According to the present invention there is provided a photopolymerisable composition for producing a screen printing stencil by the direct emulsion method, the composition comprising:-

(a) an aqueous, partially-saponified, polyvinyl acetate solution in which is dissolved a photosensitive material capable of insolubilising the saponified polyvinyl acetate under the action of actinic light; and

(b) at least one acrylated prepolymer and a photoinitiator for cross-linking the prepolymer on exposure to actinic light dispersed therein; the acrylated prepolymer being immiscible with water and also being a non-solvent for the saponified polyvinyl acetate.

Using compositions of the present invention, good exposure latitude can be achieved with easier stencil removal than hitherto, whilst maintaining tough resists with good definition.

The acrylated prepolymer, or mixtures thereof, may, if desired, be used in solution in a water-insoluble solvent, or mixtures thereof. Such solvents should be non-solvents for the polyvinyl alcohol.

The photoinitiator serves to cross-link the non-aqueous liquid phase on exposure to actinic light.

Compositions according to the invention can be prepared by dispersing a combination of a photoinitiator, an acrylated prepolymer, and optionally a solvent, in either an aqueous polyvinyl alcohol solution or a blend of an aqueous polyvinyl alcohol solution and an aqueous dispersion of a synthetic polymer or mixture of synthetic polymers to give a homogeneous blend.

Other ingredients which can be included are pigments and dyes for colouration, surfactants and defoamers to improve coating properties, inorganic and organic fillers for increased solids for economy, and plasticisers.

The photosensitive material capable of insolubilising the polyvinyl alcohol is preferably a diazo resin, or a dichromate salt, and sufficient should be present in the composition to insolubilise the polyvinyl alcohol after coating, drying and exposure of the stencil to actinic light. The diazo resin can be of the type described in British Patent Specifications 998838 or 1069366, or it can be more complex, for example an aromatic diazo compound which has to be polymerised by condensation with a condensable active carbonyl compound. The aromatic diazo compound may be partially replaced with non-diazo containing reactive compounds, for example phenols, or phenolic ethers. The -NH-group of the diazo compounds described in British Patent Specification 998838 may be replaced with -O-, -S-or -OONH groups. As is well known in the art examples of dichromate salts which can be used are potassium dichromate, sodium dichromate and ammonium dichromate.

Compositions of the invention can be used by coating on to a screen mesh and then dried using a cold or warm airstream. Imagewise exposure results in insolubilisation of the polyvinyl alcohol, for example by the diazo resin or dichromate salt, and crosslinking of the acrylated prepolymer intimately dispersed with the polyvinyl alcohol.

The resultant stencil can be developed easily with cold water, and when dried they have been found to be surprisingly solvent resistant and capable of great toughness and durability. By the judicious choice of prepolymer a considerable variation in stencil properties can be achieved. In particular, acrylated epoxy prepolymers have given particularly good build and definition. The prepolymer plus dissolved photoinitiator has not been found to scatter light on exposure, thereby providing particularly good latitude and resolution.

While prior art use of acrylated prepolymers has resulted in stencils which are difficult to remove after use, stencils produced using compositions of the present invention have been easily stripped by degrading the polyvinyl alcohol in conventional manner using sodium metaperiodate.

Preferred acrylated prepolymers are obtained by reacting an epoxy, polyester, silicone or urethane prepolymer having hydroxyl and/or epoxy groups with a terminally unsaturated carboxylic acid, or an ester thereof, preferably containing from 3 to 5 carbon atoms in the acid moiety to form an unsaturated ester by reaction with the hydroxyl or epoxy groups present in the prepolymer. The amount of acrylated prepolymer within dried films of compositions of the invention is preferably from 5 to 90% by weight, more preferably from 20 to 50% by weight.

The optional non-water miscible solvent for the prepolymer can be non-polymerisable or photopolymerisable. Preferred photopolymerisable solvents include mono-, di-, or tri-functional terminally ethylenically unsaturated monomers or mixtures thereof capable of producing a true solution with the unsaturated acrylated prepolymer and forming a stable emulsion or dispersion in the aqueous polyvinyl alcohol solution. Examples of such solvents include hexane diol-diacrylate, N-vinyl pyrrolidone, polyethylene glycol diacrylate, triethylene glycol diacrylate, tripropylene glycol diacrylate, tetraethylene glycol diacrylate, and trimethylolpropane triacrylate.

Preferred photoinitiators absorb actinic radiation at wavelenghts above 325 nm, e.g. thioxanthone derivatives, substituted benzophenones, and 1,1-dimethoxyacetophenones. However, any photoinitiator can be used provided it is soluble in and compatible with the acrylate prepolymer or solution thereof and is capable of forming free radicals on irradiation with actinic light of the appropriate wavelength. The amount of photoinitiator used is preferably from 0.5 to 5% and advantageously from 1.5 to 3.5% by weight of the prepolymer.

Accelerators or secondary initiators can also be used. These can be compounds containing at least one tertiary nitrogen atom. The proportion of accelerator present will usually be not greater than 5% by weight of the prepolymer.

The partially-saponified polyvinyl acetate can be hydrolised to an extent of from 75 to 95%, but the degree of aponification should not be so low as to render it soluble in the prepolymer or the optional solvent for the prepolymer. Alternative substituents can be present in the prepolymer, for example to aid solubility when developing, or water resistance in the finished stencil.

The compositions of the invention can, with advantage, also include an aqueous dispersion of a water dispersible polymer. Examples include polyvinyl acetate, or co-and ter-polymers of vinyl acetate with other ethylenically unsaturated monomers, e.g vinyl chloride, vinyl laurate, ethylene, or N-methylol acrylamide. The proportion of water dispersible polymer in a dried coating of a composition of the invention can be up to 70% by weight. Preferred levels are from 20 to 60% by weight.

The amount of aqueous, partially-saponified, polyvinyl acetate solution present will in general be from 5 to 50% by weight based on the weight of the dried composition, preferably from 7 to 35% by weight.

The following Examples are given by way of illustration only. All parts are by weight.

## Example 1

Hexafunctional acrylated polyester prepolymer-(Ebecryl 850 - supplied by UCB S.A.)    65

Trimethylolpropane triacrylate    15

2-Chlorothioxanthone    1

Methyl diethanolamine    2

88% Hydrolysed polyvinyl acetate (Gohsenol GH20 - 13% aqueous soln.)    120

Diazo resin (ZAL18 - supplied by ABM) 1
Water    40

Pigment dispersion (Imperon Violet) 0.2

The 2-chlorothioxanthone was dissolved into the blended mixture of methyl diethanolamine, trimethylolpropane triacrylate and the hexafunctional acrylated polyester prepolymer. The resulting solution was then stirred into the hydrolysed polyvinyl acetate until homogeneously dispersed. The pigment dispersion was stirred into the mix until even in colour throughout. Finally, the diazo resin was added with the water, and stirring was continued until the resin had dissolved fully.

This emulsion was coated on a polyester mesh having 120 threads per centimetre, applying 1 coat to the print side and three coats to the squeegee side of the mesh. The coating was dried with air at 35°C, and it was exposed through a photographic positive transparency to a 3kw mercury halide lamp at a distance of 1.2 metres for 6 minutes. The stencil was developed with a gentle cold water spray, and dried.

The resultant stencil showed good definition and build properties, and when rubbed whilst immersed in cyclohexanone using a polyurethane squeegee it was found to be extremely resistant to swelling, wear and damage.

Removal of the stencil from the screen was easily achieved by brushing with a 2% solution of sodium metaperiodate in water.

## Example 2

Hexafunctional acrylated urethane prepolymer (Photomer 6316 Lankro Chemicals Ltd.)    25
Benzyldimethyl ketal    0.75

Methyl diethanolamine    1.0

86% Hydrolysied polyvinyl acetate (Gohsenol GH20 - 13% aqueous soln)    50

Aqueous dispersion of ethylene - vinyl acetate copolymer (Vinamul 3253 - Vinamul Ltd.) 75

Pigment dispersion (Imperon Violet) 0.2

Diazo resin (ZAL18) 1.0

The hexafunctional acrylated urethane prepolymer and methyl diethanolamine were blended together, and into the blend was dissolved the benzyl dimethyl ketal free radical photoinitiator. This solution was then stirred into the previously blended mixture of hydrolysed polyvinyl acetate solution and the aqueous dispersion of an ethylene-vinyl acetate copolymer. An homogenous mixture was easily achieved into which was stirred the pigment dispersion. The diazo resin was added and stirring was continued until fully dissolved.

The resultant emulsion was coated, dried, exposed and developed as described in Example 1.

The stencil showed good definition and build properties, and when rubbed whilst immersed in cyclohexanone using a polyurethane squeegee it was found to be extremely resistant to swelling, wear and damage.

Removal of the stencil from the screen was easily achieved by brushing with a 2% solution of sodium metaperiodate in water.

Example 3
Hexafunctional acrylated urethane prepolymer (Photomer 6316) 25

86% Hydrolysed polyvinyl acetate (Gohsenol GH20 - 13% aqueous soln) 50

Aqueous dispersion of ethylene - vinyl acetate copolymer (Vinamul 3253) 75

Pigment dispersion (Imperon Violet) 0.2

Diazo resin (ZAL18) 1.0

The emulsion was made as for Example 2 except for the absence of the benzyl dimethyl ketal and methyl diethanolamine co-initiator system.

The emulsion was coated, dried, exposed and developed as Example 1.

The resultant stencil did not develop. Unexposed areas were not removed by the cold water spray and when dried these areas showed considerable tackiness.

Example 4
Hexafunctional acrylated urethane prepolymer (Photomer 6316) 25

Benzyldimethyl ketal 0.75

Methyl diethanolamine 1.0

86% Hydrolysed polyvinyl acetate (Gohsenol GH20 -13% aqueous soln) 50
Aqueous dispersion of ethylene - vinyl acetate copolymer (Vinamul 3253) 75
Pigment dispersion (Imperon Violet) 0.2

The emulsion was made as for Example 2 except that the diazo resin powder was omitted.

The emulsion was coated, dried, exposed and developed as for Example 1.

On developing, the majority of the stencil, both exposed and unexposed areas, washed away. On drying, a thin colourless layer filled all coated areas of the screen and exhibited tackiness in the unexposed areas.

Example 5
Difunctional acrylated epoxy prepolymer (Ebercryl 600 - supplied by UCB S.A.) 60

Dibutyl phthalate 20

2-Chlorothioxanthone 0.7

Methyl diethanolamine 1.0

88% Hydrolysed polyvinyl acetate (Gohsenol GH20 - 13% aqueous soln) 100

Diazo resin (ZAL18) 1.0

Pigment dispersion (Imperon Violet) 0.2

Water 40

An emulsion was prepared by dissolving the 2-chlorothioxanthone free radical photo-initiator in the dibutyl phthalate which was then blended with the methyl diethanolamine and the difunctional acrylated epoxy prepolymer. The resulting solution was stirred into the aqueous solution of the hydrolysed polyvinyl acetate until homogenous. The pigment dispersion was added and stirred until an even colour was achieved. The water and the diazo resin were then added to the emulsion, and the mixture was stirred until all the resin had dissolved.

The mixture was coated, dried, exposed and developed as Example 1.

The resultant stencil showed good definition and build properties, and when rubbed whilst immersed in cyclohexanone with a polyurethane squeegee it was found to be extremely resistant to swelling, wear and damage.

Removal of the stencil from the screen was easily achieved by brushing with a 2% solution of sodium metaperiodate in water.

## Claims

1. A photopolymerisable composition for producing a screen printing stencil by the direct emulsion method, the composition comprising:-

(a) an aqueous, partially-saponified, polyvinyl acetate solution in which is dissolved a photosensitive material capable of insolubilising the saponified polyvinyl acetate under the action of actinic light; and

(b) at least one acrylated prepolymer and a photoinitiator for cross-linking the prepolymer on exposure to actinic light dispersed therein; the acrylated prepolymer being immiscible with water and also being a non-solvent for the saponified polyvinyl acetate.

2. A composition as claimed in claim 1, wherein the acrylated prepolymer is selected from an epoxy prepolymer reacted with a terminally unsaturated carboxylic acid, a polyester prepolymer reacted with a terminally unsaturated carboxylic acid, a urethane prepolymer reacted with a terminally unsaturated carboxylic acid, a silicone prepolymer reacted with a terminally unsaturated carboxylic acid, and esters of such reaction products.

3. A composition as claimed in claim 1, wherein the photoinsolubilising system comprises a diazo sensitiser or a dichromate salt.

4. A composition as claimed in claim 1, including a solvent for the prepolymer, the solvent comprising at least one of hexane diol diacrylate, N-vinyl pyrrolidone, polyethylene glycol diacrylate, tripropylene glycol diacrylate, tetraethylene glycol diacrylate and trimethylolpropane triacrylate.

5. A composition as claimed in claim 1, wherein the aqueous saponified polyvinyl acetate has a hydrolysis level of from 75 to 95%.

6. A composition according to claim 1, containing an aqueous dispersion of a synthetic polymer, preferably a dispersion of a polyurethane or an addition copolymer of at least one of the monomers vinyl ester, vinyl chloride and ethylene.

7. A composition as claimed in claim 6, containing up to 70% by weight of the synthetic polymer based on the weight of the dried composition.

8. A composition as claimed in claim 1, containing from 5 to 90 percent of acrylated prepolymer based on the dried weight of the composition.

9. A composition as claimed in claim 1, containing from 5 to 50% by weight of partially saponified polyvinyl acetate based on the dried composition.

10. A composition as claimed in claim 1, wherein the at least one acrylated prepolymer and the photoinitiator are dissolved in a solvent which is water immiscible and is a non-slovent for the saponified polyvinyl acetate.